Europäisches Patentamt

European Patent Office

Office européen des brevets

(19)

(11) EP 0 623 257 B1

(12) **EUROPÄISCHE PATENTSCHRIFT**

(45) Veröffentlichungstag und Bekanntmachung des Hinweises auf die Patenterteilung:
**23.04.1997 Patentblatt 1997/17**

(21) Anmeldenummer: 93921800.4

(22) Anmeldetag: **07.10.1993**

(51) Int Cl.$^6$: **H03K 17/08**, H03K 17/14

(86) Internationale Anmeldenummer:
**PCT/DE93/00949**

(87) Internationale Veröffentlichungsnummer:
**WO 94/10753 (11.05.1994 Gazette 1994/11)**

(54) **MONOLITHISCH INTEGRIERTES MOS-ENDSTUFENBAUTEIL MIT EINER ÜBERLAST-SCHUTZEINRICHTUNG**

MONOLITHIC INTEGRATED MOS HIGH-LEVEL STAGE COMPONENT WITH AN OVERLOAD PROTECTION ARRANGEMENT

COMPOSANT D'ETAGE DE SORTIE MOS INTEGRE MONOLITHIQUE MUNI D'UN DISPOSITIF ANTI-SURCHARGE

(84) Benannte Vertragsstaaten:
**DE FR GB IT**

(30) Priorität: **28.10.1992 DE 4236334**

(43) Veröffentlichungstag der Anmeldung:
**09.11.1994 Patentblatt 1994/45**

(73) Patentinhaber: **ROBERT BOSCH GMBH**
**70442 Stuttgart (DE)**

(72) Erfinder:
• **TOPP, Rainer**
**D-72768 Stuttgart (DE)**

• **UEBELE, Manfred**
**D-72760 Reutligen (DE)**

(56) Entgegenhaltungen:
**EP-A- 0 384 937          EP-A- 0 428 813**
**DE-A- 3 433 538          DE-A- 3 821 065**

• **PATENT ABSTRACTS OF JAPAN, Bd. 014, Nr. 533 (E-1005)22. November 1990;& JP-A-02 226 808**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

STAND DER TECHNIK

Die Erfindung betrifft ein monolithisch integriertes MOS-Endstufenbauteil, insbesondere eine DMOS-Endstufe. mit einem einen GATE-, einen SOURCE und einen DRAIN-Anschluß aufweisenden Endstufenelement sowie mit einer Überlast-Schutzeinrichtung.

Überlast-Schutzeinrichtungen sind in verschiedenen diskreten Schaltungsvarianten bekannt. Hierbei bedarf die jeweilige Anpassung an das jeweilige Endstufenbauteil eines besonderen Aufwandes, und die physikalischen Grenzen des Halbleiters können nur in beschränktem Maße ausgenutzt werden.

Die DE 38 21 065 A1 zeigt in Figur 39 eine herkömmliche Leistungs-MOSFET-Einrichtung mit Temperaturschutz mit Gatevorwiderstand zur monolithischen Integration.

VORTEILE DER ERFINDUNG

Das erfindungsgemäße MOS-Endstufenbauteil mit den kennzeichnenden Merkmalen des Hauptanspruchs hat den Vorteil einer kostengünstigen Realisierung durch eine monolithisch integrierte Lösung bei verbesserter Schutzfunktion und stärkerem Ausnutzen der physikalischen Grenzen des Halbleiters. Durch die Pegelanpassungsstufe steht für die sichere Funktion der Überlast- bzw. Leistungsbegrenzung eine ausreichend hohe Versorgungsspannung zur Verfügung, um die Verlustleistung bis auf den Wert Null zu begrenzen. Die Eingangsspannung (GATE-SOURCE-Spannung des Endstufenbauteils) oder der Sense-Strom aus einer Sense-Zelle des Endstufenbauteils kann als Meßgröße für den Ausgangs- bzw. DRAIN-Strom Id benutzt werden. Die Pegelanpassung erfolgt zweckmäßigerweise durch Abgleich in der Weise, daß die Steuerkennlinie Id = f (Ugs) einen negativen Temperaturkoeffizienten aufweist und den Ausgangsstrom bei steigender Chip-Temperatur stabilisierend begrenzt. Dies kann beispielsweise durch geeignete Wahl des Temperaturkoeffizienten einer Referenzspannungsquelle oder durch geeignete Kombination der Widerstands-Temperaturkoeffizienten der beteiligten Widerstände erfolgen.

Durch die in den abhängigen Ansprüchen aufgeführten Maßnahmen sind vorteilhafte Weiterbildungen und Verbesserungen des im Hauptanspruch angegebenen Endstufenbauteils möglich.

Die Pegelanpassungsstufe ist in vorteilhafter Weise als Stromspiegel ausgebildet, deren erster Zweig den GATE-Anschluß des Endstufenelements mit dem SOURCE-Anschluß verbindet und dessen zweiter Zweig mit einem Referenzstrom beaufschlagt wird. Hierzu ist eine Referenzspannungsquelle mit diesem zweiten Zweig verbunden, die vom äußeren GATE-Anschluß gespeist wird. Hierdurch wird der integrierte GATE-Vorwiderstand mit einer definierten Durchströmung angesteuert, und die dadurch gebildete Pegelanpassung verschiebt die Übertragungskennlinie der Endstufe um einen definierten Spannungs-Offsetwert und hebt die externe Schwellspannung der Endstufe an, das heißt, unterhalb dieses Wertes fließt kein Ausgangsstrom in der Endstufe. Gleichzeitig wird dadurch die genannte feste Zuordnung Ugs = f (Id) erzeugt, so daß die Eingangsspannung Ugs als Meßgröße für den fließenden Ausgangsstrom Id benutzt werden kann.

Die zu überwachende Verlustleistung beträgt P = Uds . Id. Sie könnte mit einem Analog-Multiplizierer exakt bestimmt werden, jedoch ist dies sehr aufwendig und in integrierter Form kaum darstellbar. Für die hier gegebenen Randbedingungen in Verbindung mit der Pegelanpassungsstufe genügt jedoch in vorteilhafter Weise eine die DRAIN-SOURCE-Spannung mit der GATE-SOURCE-Spannung additiv verknüpfende Addierstufe, um in schaltungstechnisch sehr einfacher Form eine gute Näherungslösung für die Multiplikation und die Bildung der Leistung bzw. Last zu erzeugen, die begrenzt werden soll. Hierzu besteht die Addierstufe in einfacher Weise aus zwei einseitig miteinander verbundenen Widerständen, über die die beiden Spannungen zu einem Summenpunkt zusammengeführt werden.

Alternativ zur Spannung Ugs kann auch diejenige Spannung als Maß für den DRAIN-Strom verwendet werden, die ein Sense-Strom Is = Id/k, der durch Sense-Zellen im SOURCE-Bereich des Endstufenelements fließt, durch Einströmen in den Summenpunkt der Regelschaltung erzeugt.

Um die Leistung im Bedarfsfall zu reduzieren, weist die Begrenzungsstufe Mittel zur Reduzierung des Widerstands eines zwischen dem äußeren GATE-Anschluß und dem SOURCE-Anschluß geschalteten MOS-Transistors bei ansteigendem Summenwert der Addierstufe auf. Hierdurch wird das Ansteuerpotential so weit reduziert, bis die der Leistung proportionale Summenspannung mit einem Referenzwert übereinstimmt.

Die in der Begrenzungsstufe enthaltenen Mittel können in einfacher Weise als vergleichender Regelverstärker ausgebildet sein, dem neben dem Summenwert ein festlegbarer Grenzwert als Referenzwert zugeführt wird. Diese Mittel können jedoch auch als mehrstufiger MOS-Regelverstärker ausgebildet sein, der mittels eines Spannungsteilers durch einen festlegbaren Teil des Summenwerts gesteuert wird.

Zusätzlich kann in vorteilhafter Weise noch ein DRAIN-SOURCE-Spannungsbegrenzer (Klammerung) für das Endstufenelement zum Schutz gegen unzulässig hohe Spannungen beim Abschalten von induktiven Lasten vorgesehen sein.

Weiterhin kann in vorteilhafter Weise zusätzlich eine Übertemperatur-Schutzeinrichtung im Endstufen-Bauteil integriert sein, so daß die Schwelle für die Lastbegrenzung nur mäßig genau sein muß, während die Übertemperatur-Schutzeinrichtung die tatsächliche Verlustleistung so weit reduziert, daß die Chip-Temperatur nicht über eine vorgesehene Grenze ansteigt.

Der Abgleich der Pegelanpassung und ein negativer Temperaturkoeffizient des Ausgangsstromes Id bei konstanter Eingangsspannung ermöglichen in vorteilhafter Weise eine modulartige Parallelschaltung von mehreren Endstufenbauteilen. Hierdurch kann der maximale Ausgangsstrom Id erhöht werden. wobei der modulare Aufbau durch die verteilte Verlustleistung einen geringen effektiven Wärmewiderstand erlaubt. Der Chip mit der niedrigsten Klammerspannung steuert die parallelgesteuerten Chips mit an. Ein Abgleich der Klammerspannung auf Grund von Streuungen der Bauelemente-Parameter aus verschiedenen Herstellungs-Chargen ist nicht erforderlich. Die Pegelanpassung wird so abgeglichen, daß Bauelemente aus verschiedenen Herstellungs-Chargen dieselbe Kennlinie (denselben Arbeitspunkt) aufweisen.

ZEICHNUNG

Ausführungsbeispiele der Erfindung sind in der Zeichnung dargestellt und in der nachfolgenden Beschreibung näher erläutert. Es zeigen:

Fig. 1    ein Gesamtschaltbild des monolithisch integrierten MOS-Endstufenbauteils mit einem ersten Ausführungsbeispiel einer Übertemperatur-Schutzeinrichtung zur Abregelung des Ausgangsstroms,

Fig. 2    ein zweites Ausführungsbeispiel einer Übertemperatur-Schutzeinrichtung mit einer Temperaturabschaltung,

Fig. 3    ein drittes Ausführungsbeispiel einer Übertemperatur-Schutzeinrichtung,

Fig. 4    ein viertes Ausführungsbeispiel einer Übertemperatur-Schutzeinrichtung,

Fig. 5    eine alternative Ausgestaltung der in Fig. 1 enthaltenen Überlast-Schutzeinrichtung und

Fig. 6    eine weitere alternative Ausgestaltung der in Fig. 1 enthaltenenen Überlast-Schutzeinrichtung,

BESCHREIBUNG DER AUSFÜHRUNGSBEISPIELE

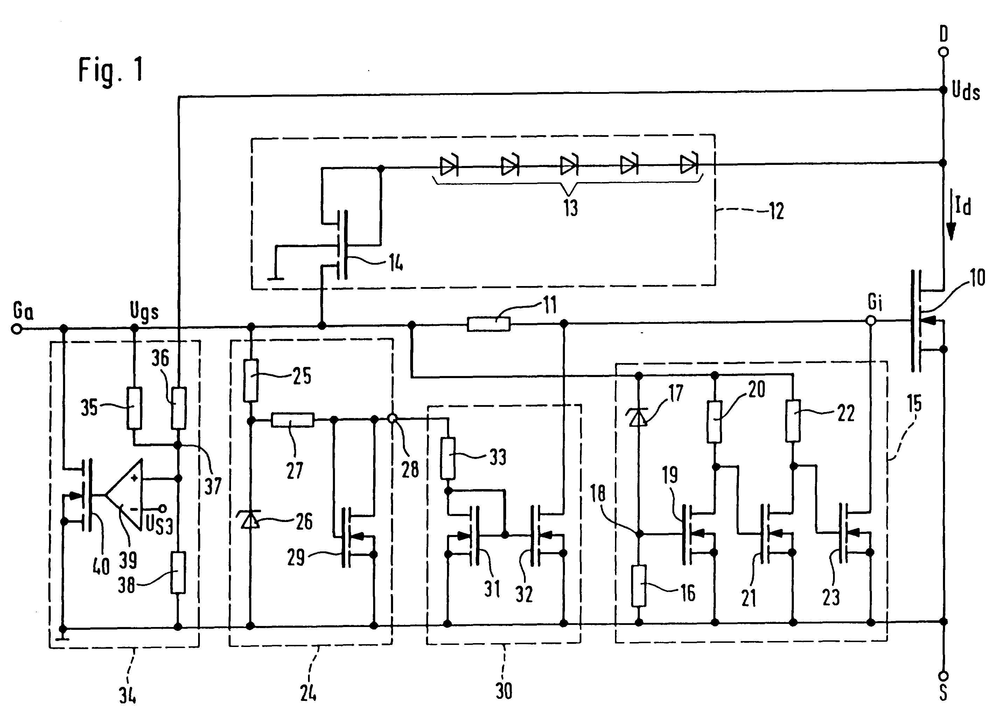

In Fig. 1 ist ein monolithisch integriertes MOS-Endstufenbauteil dargestellt, das beispielsweise als DMOS-Endstufe ausgebildet ist. Es besteht im wesentlichen aus einem als MOS-npn-Transistor ausgebildeten Endstufenelement 10 als steuerbares Halbleiterelement. Dieses Endstufenelement 10 weist in bekannter Weise einen DRAIN-Anschluß D, einen SOURCE-Anschluß S und einen GATE-Anschluß Gi auf. Dem GATE-Anschluß Gi ist ein GATE-Vorwiderstand 11 vorgeschaltet, dessen vom Endstufenelement 10 abgewandter Anschluß den äußeren GATE-Anschluß Ga des gesamten Endstufenbauteils bildet. Zwischen dem DRAIN-Anschluß D und dem äußeren GATE-Anschluß Ga ist ein DRAIN-SOURCE-Spannungsbegrenzer 12 geschaltet, der in üblicher Weise auch als Klammerung bezeichnet wird. Dieser Spannungsbegrenzer 12 besteht im wesentlichen aus der Reihenschaltung einer Vielzahl von Z-Dioden 13 mit einem als Diode geschalteten MOS-Transistor 14, dessen SOURCE-Anschluß mit dem äußeren GATE-Anschluß Ga des gesamten Endstufenbauteils verbunden ist und dessen BULK-Anschluß an Masse bzw. am SOURCE-Anschluß des gesamten Endstufenbauteils liegt. Die Zahl der Z-Dioden 13 hängt von der gewünschten maximal zulässigen Spannung ab. Wird diese Spannung z.B. beim Abschalten von induktiven Lasten überschritten, so wird durch den Stromfluß durch diese Z-Dioden ein weiterer Anstieg der DRAIN-Spannung verhindert.

Eine Übertemperatur-Schutzeinrichtung 15 besteht im wesentlichen aus der Reihenschaltung eines temperaturabhängigen Widerstands 16 mit einer Z-Diode 17, wobei der temperaturabhängige Widerstand 16 einen positiven Temperaturkoeffizienten aufweist. Diese Reihenschaltung ist zwischen den äußeren GATE-Anschluß Ga und den SOURCE-Anschluß S des Endstufenbauteils geschaltet, wobei der Widerstand 16 am SOURCE-Anschluß und die Z-Diode 17 am äußeren GATE-Anschluß Ga liegt. Ein zwischen dem Widerstand 16 und der Z-Diode 17 liegender Abgriff 18 dieses Spannungsteilers ist mit dem GATE-Anschluß eines MOS-Transistors 19 verbunden. dessen DRAIN-SOURCE-Strecke in Reihe mit einem Widerstand 20 zwischen den äußeren GATE-Anschluß Ga und den SOURCE-Anschluß S des Endstufenbauteils geschaltet ist. Dabei liegt der Widerstand 20 am äußeren GATE-Anschluß Ga. Der Verknüpfungspunkt zwischen dem Widerstand 20 und dem MOS-Transistor 19 ist mit dem GATE-Anschluß eines weiteren MOS-Transistors 21 verbunden, der zusammen mit einem Widerstand 22 eine entsprechende Reihenschaltung bildet. Der Abgriff zwischen dem Widerstand 22 und dem MOS-Transistor 21 ist mit dem GATE-Anschluß eines dritten MOS-Transistors 23 verbunden, dessen DRAIN-SOURCE-Strecke zwischen den inneren GATE-Anschluß Gi und den SOURCE-Anschluß S des Endstufenbauteils geschaltet ist.

Die Übertemperatur-Schutzeinrichtung 15 ist im dargestellten Ausführungsbeispiel zur Stromversorgung mit dem äußeren GATE-Anschluß Ga verbunden. Alternativ hierzu kann zur Spannungsversorgung selbstverständlich auch eine Referenzspannungsquelle verwendet werden, die beispielsweise gemäß der Referenzspannungsquelle 24 in Fig. 1 aufgebaut ist.

Die ein temperatursensitives Element bildende Z-Diode 17 weist eine sehr hohe Empfindlichkeit auf. Ihr Sperrstrom verdoppelt sich je 10 K Temperaturerhöhung. Gleichzeitig nimmt bei einer Temperaturerhöhung der Widerstandswert des temperaturabhängigen Widerstands 16 zu, so daß bei einer Temperaturerhöhung der Strom durch diese Reihenschaltung und damit die Spannung am Abgriff 18 steil ansteigt. Auch der MOS-Transistor 19 stellt ein temperaturabhängiges Bauteil dar, das bei einer Temperaturerhöhung schon bei niedrigeren Spannungen anspricht. Hierdurch ergibt sich durch Zusammenwirken dieser Bauteile insgesamt eine hohe Gesamtsteilheit für das Auswertesignal und eine geringe Temperaturunschärfe bei prozeßbedingter Streuung der Bauelemente-Parameter. Der gewünschte Temperaturschaltpunkt bzw. Einsatzbeginn der Temperaturabregelung kann durch Abgleich dieses Widerstands 16 bzw. durch entsprechende Wahl seines Widerstandswerts festgelegt werden. Bei mittleren Genauigkeitsanforderungen kann auf einen exakten Abgleich auch verzichtet werden.

Bei ansteigender Chip-Temperatur steigt somit die Steuerspannung am Abgriff 18 an, was einen vergrößerten Strom durch den MOS-Transistor 19, entsprechend einen verringerten Strom durch den MOS-Transistor 21 und folglich einen erhöhten Strom durch den MOS-Transistor 23 zur Folge hat. Somit wird bei zunehmender Chip-Temperatur die GATE-Spannung am inneren GATE-Anschluß Gi bis zum thermischen Gleichgewicht reduziert, also abgeregelt.

In der Referenzspannungsquelle 24 ist die Reihenschaltung eines Widerstands 25 mit einer Z-Diode 26 zwischen den äußeren GATE-Anschluß Ga und den SOURCE-Anschluß S geschaltet, wobei die Z-Diode 26 am SOURCE-Anschluß S liegt. Der Verknüpfungspunkt zwischen diesen beiden Bauteilen ist über einen Widerstand 27 mit einem Ausgang 28 der Referenzspannungsquelle 24 verbunden. Zwischen dem Ausgang 28 und dem SOURCE-Anschluß des Endstufenelements 10 ist die DRAIN-SOURCE-Strecke eines MOS-Transistors 29 geschaltet, dessen GATE-Anschluß ebenfalls am Ausgang 28 liegt.

Im Betrieb liegt an der Kathode der Z-Diode 26 die Z-Spannung an. Bei einer Spannungserhöhung wird der MOS-Transistor 29 stärker durchgesteuert, so daß die Ausgangsspannung der Referenzspannungsquelle 24 auf einen konstanten Wert geregelt wird.

Eine als Stromspiegel ausgebildete Pegelanpassungsstufe 30 besitzt zwei MOS-Transistoren 31,32 in einer Stromspiegelschaltung, das heißt, die beiden GATE-Anschlüsse sind miteinander verbunden und die beiden SOURCE-Anschlüsse an den SOURCE-Anschluß des Endstufenbauteils angeschlossen. Der DRAIN-Anschluß des MOS-Transistors 31 ist mit den beiden GATE-Anschlüssen sowie über einen Widerstand 33 mit dem Ausgang 28 der Referenzspannungsquelle 24 verbunden. Der DRAIN-Anschluß des MOS-Transistors 32 ist mit dem inneren GATE-Anschluß Gi des Endstufenelements 10 verbunden.

Infolge der festen Referenzspannung am Ausgang 28 fließt durch den linken Zweig der Pegelanpassungsstufe 30, also durch den MOS-Transistor 31, ein konstanter Strom, so daß infolge des Stromspiegels durch den MOS-Transistor 32 ebenfalls ein konstanter Strom fließt. Hierdurch ergibt sich eine definierte Durchströmung des GATE-Vorwiderstands 11, und die dadurch gebildete Pegelanpassung verschiebt die Übertragungskennlinie der Endstufe um einen definierten Spannungs-Offsetwert und hebt die externe Schwellspannung der Endstufe an, das heißt, unterhalb dieses Werts fließt kein Ausgangsstrom zum Endstufenelement 10. Gleichzeitig wird hierdurch eine feste Zuordnung des DRAIN-Stroms Id zur externen GATE-SOURCE-Spannung Ugs am externen GATE-Anschluß Ga erzeugt, die über einen Abgleich festgelegt wird. Die Eingangsspannung Ugs kann nun als Meßgröße für den fließenden Ausgangsstrom Id des Endstufenbauteils benutzt werden. Hierbei wird die Pegelanpassung so gewählt, daß die Steuerkennlinie Id = f (Ugs) einen negativen Temperaturkoeffizienten aufweist und den Ausgangsstrom bei steigender Chip-Temperatur stabilisierend begrenzt. Dies kann z.B. durch geeignete Wahl des Temperaturkoeffizienten der Referenzspannung am Ausgang 28 oder durch geeignete Kombination der Temperaturkoeffizienten der Widerstände 33 und 11 erfolgen.

In einer Begrenzungsstufe 34 sind die Spannungen Ugs am äußeren GATE-Anschluß Ga und die DRAIN-SOURCE-Spannung Uds am DRAIN-Anschluß D des Endstufenelememnts 10 über zwei Widerstände 35,36 an einem Summenpunkt 37 zusammengeführt, der über einen weiteren Widerstand 38 am SOURCE-Anschluß S des Endstufenelements 10 liegt. Die aufsummierten Spannungen am Summenpunkt 37 sind dem nichtinvertierenden Eingang eines vergleichenden Regelverstärkers 39 zugeführt, an dessen Vergleichseingang eine Vergleichsspannung $U_{S3}$ liegt. Der Regelverstärker 39 steuert den GATE-Anschluß eines MOS-Transistors 40, dessen DRAIN-SOURCE-Strecke zwischen den äußeren GATE-Anschluß Ga und den SOURCE-Anschluß S des Endstufenelements 10 geschaltet ist.

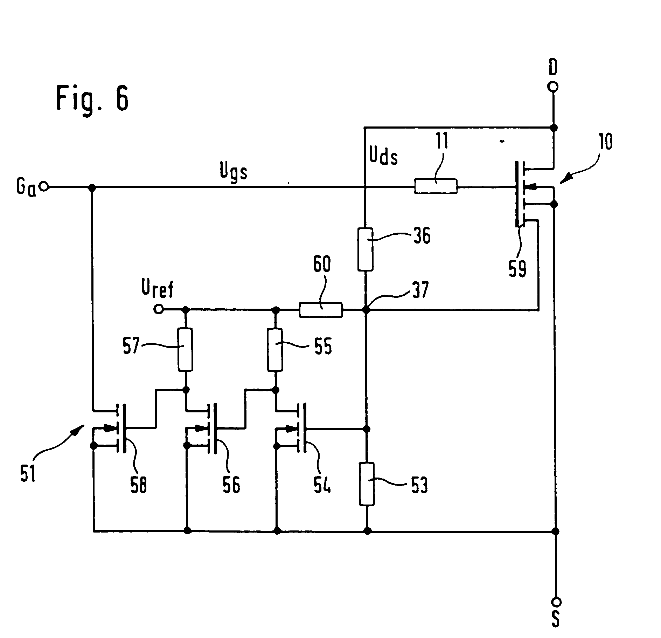

Anstelle über den Widerstand 35 kann der Regelschaltung die Information über die Größe des DRAIN-Stroms Id durch einen Sense-Strom vom Endstufenelement 10 zugeführt werden, der in den Summenpunkt 37 der Regelstufe bzw. Begrenzungsstufe 34 einströmt. Diese Alternative wird in Zusammenhang mit Fig. 6 noch näher erläutert.

Die Verlustleistung des Endstufenelements 10 beträgt Uds . Id. Sie könnte mit einem Analog-Multiplizierer exakt bstimmt werden, jedoch ist dies sehr aufwendig und in integrierter Form kaum darstellbar. Infolge der Pegelanpassungsstufe 30 ist jedoch die Spannung Ugs proportional zum Strom Id. Für die hier gegebenen Randbedingungen (analoger Betrieb) gilt die Näherungslösung für die Verlustleistung P:

$$P = k_1 . Uds + k_2 . Ugs.$$

Diese Addition wird durch die beiden Widerstände 35,36 durchgeführt, so daß am Summenpunkt 37 ein von der Verlustleistung P abhängiger Spannungswert vorliegt. Durch den Regelverstärker 39 soll die Verlustleistung auf den Wert $U_{S3}$ begrenzt werden, das heißt, übersteigt der verlustleistungsabhängige Spannungswert am Summenpunkt 37 den Wert U_{S3}, so wird der MOS-Transistor 40 aufgesteuert, was eine Verringerung der Spannung Ugs am äußeren GATE-Anschluß Ga zur Folge hat. Hierdurch erfolgt eine Leistungsbegrenzung und ein Schutz gegen Überlastung des Endstufenelements 10. An den Randbereichen, das heißt bei sehr kleinen Werten Uds bzw. Id, erfolgt wegen der Addition von Uds und Id eine stärkere Begrenzung der Verlustleistung.

Hierdurch können die physikalischen Grenzen des Endstufenbauteils bzw. des Endstufenelements 10 stärker ausgenutzt werden. Durch die Pegelanpassung steht für die sichere Funktion der Leistungsbegrenzung eine ausreichend hohe Versorgungsspannung zur Verfügung, um die Verlustleistung bis auf den Wert Null zu begrenzen. Die Kombination der Leistungsbegrenzung durch die Begrenzungsstufe 34 und die Übertemperatur-Abregelung durch die Übertemperatur-Schutzeinrichtung 15 läßt eine relativ genaue Schwelle für die Leistungsbegrenzung zu, während die Übertemperatur-Abregelung die tatsächliche Verlustleistung so weit reduziert, daß die Chip-Temperatur nicht über eine vorgegebene Grenze ansteigen kann. Der Abgleich der Pegelanpassung auf eine gleiche Steuerkennlinie einerseits und ein negativer Temperaturkoeffizient des Ausgangsstroms Id bei konstanter Eingangsspannung andererseits ermöglichen eine problemlose Parallelschaltung von mehreren Endstufenbauteilen bzw. Chips. Der Chip mit der niedrigsten Klammerspannung steuert die parallelgeschalteten Chips mit an. Ein Abgleich der Klammerspannung wegen Streuungen der Bauelemente-Parameter aus verschiedenen Herstellungs-Chargen ist nicht erforderlich. Die Pegelanpassung durch die Pegelanpassungsstufe 30 erfolgt in der Weise, daß Bauelemente aus verschiedenen Herstellungs-Chargen dieselbe Kennlinie (denselben Arbeitspunkt) aufweisen. Außerdem bekommt der Ausgangsstrom Id bei konstanter Eingangsspannung einen negativen Temperaturgang, um Unsymmetrien des Ausgangsstroms verschiedener Chips entgegenzuwirken. Durch Parallelschalten von mehreren Chips kann der maximale Ausgangsstrom Id erhöht werden. Der modulare Aufbau erlaubt durch die verteilte Verlustleistung einen geringen effektiven Wärmewiderstand.

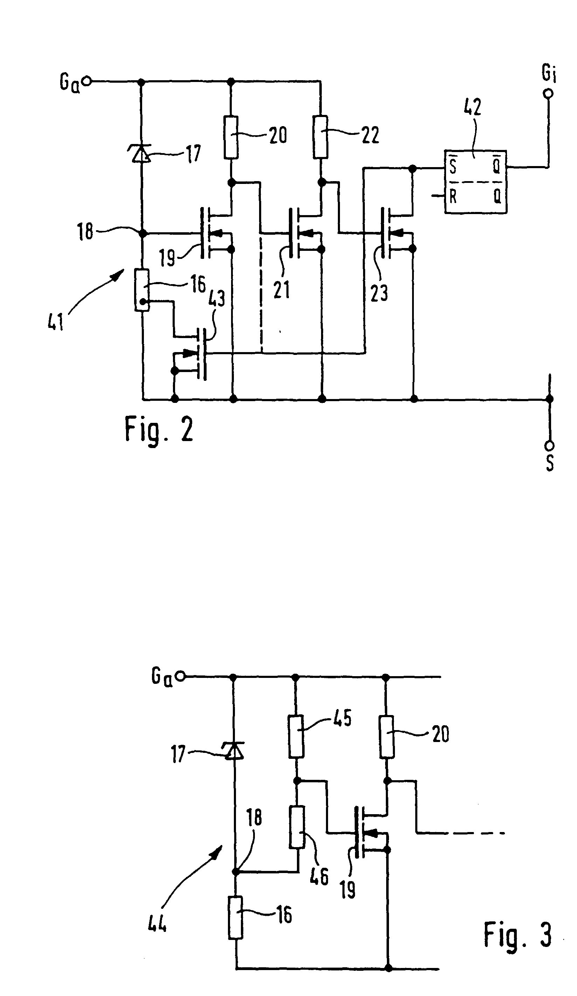

Die in Fig. 2 dargestellte Übertemperatur-Schutzeinrichtung 41 kann anstelle der Übertemperatur-Schutzeinrichtung 15 gemäß Fig. 1 treten. Im Unterschied zur Übertemperatur-Schutzeinrichtung 15 ist nunmehr der DRAIN-Anschluß des MOS-Transistors 23 mit dem Setzeingang S̄ eines Flipflops 42 verbunden, dessen Ausgang Q̄ an den inneren GATE-Anschluß Gi des Endstufenelements 10 angeschlossen ist. Weiterhin ist ein Teilbereich des temperaturabhängigen Widerstands 16 über die DRAIN-SOURCE-Strecke eines MOS-Transistors 43 kurzschließbar, dessen GATE-Anschluß mit dem Setzeingang S̄ des Flipflops 42 verbunden ist.

Diese Übertemperatur-Schutzeinrichtung 41 bewirkt eine Übertemperatur-Abschaltung. Steigt die Spannung am Abgriff 18 über einen bestimmten Wert an, so wird das Flipflop 42 durchgeschaltet und zieht den inneren GATE-Anschluß Gi des Endstufenelements 10 nach Masse bzw. auf das Potential des SOURCE-Anschlusses S. Hierdurch erfolgt eine plötzliche Abschaltung des Endstufenelements 10 ab einer bestimmten Übertemperatur. Das Rücksetzen des Flipflops 42 zur Wiederaufnahme des Betriebs des Endstufenelements 10 kann entweder beim Wiedereinschalten einer Versorgungsspannung erfolgen oder zeitgesteuert nach einer vorgebbaren Zeit oder in Abhängigkeit der Spannung am Abgriff 18, wenn diese einen bestimmten Wert unterschritten hat.

Durch den MOS-Transistor 43 wird eine Schalthysterese realisiert. Bei zunächst gesperrtem MOS-Transistor 23 leitet der MOS-Transistor 43, so daß ein Teil des temperaturabhängigen Widerstands 16 kurzgeschlossen ist. Bei einer bestimmten Chip-Temperatur wird der MOS-Transistor 43 so durchgesteuert, daß das Flipflop 42 schaltet. Durch dasselbe Signal wird der MOS-Transistor 43 gesperrt, so daß nun der gesamte Widerstandswert des temperaturabhängigen Widerstands 16 wirksam wird und die Spannung am Abgriff 18 dadurch sprunghaft ansteigt. Hierdurch wird ein schnelles Wiedereinschalten verhindert und eine Hysterese erreicht. Diese Hysterese ist selbstverständlich auch bei einer Übertemperatur-Abregelung gemäß Fig. 1 einsetzbar, das heißt auch bei nicht vorhandenem Flipflop 42. Die Steuerung des MOS-Transistors 43 kann auch durch die Spannung am GATE-Anschluß des MOS-Transistors 21 erfolgen, wie dies durch eine gestrichelte Linie angedeutet ist.

Das in Fig. 3 dargestellte weitere Ausführungsbeispiel einer Übertemperatur-Schutzeinrichtung 44 kann ebenfalls anstelle der Übertemperatur-Schutzeinrichtung 15 treten. Gleiche oder gleich wirkende Bauteile sind mit denselben Bezugszeichen versehen und nicht nochmals beschrieben. Auf die Darstellung des zweiten und dritten MOS-Transistors 21 und 23 wurde zur Vereinfachung verzichtet. Diese können selbstverständlich ebenfalls vorgesehen sein. In Abwandlung zu den bisherigen Ausführungsbeispielen ist nunmehr ein aus zwei Widerständen 45,46 bestehender Spannungsteiler parallel zur Z-Diode 17 geschaltet, wobei der Abgriff zwischen den Widerständen 45,46 mit dem GATE-Anschluß des MOS-Transistors 19 verbunden ist.

Die Anode der Z-Diode 17 stellt die Basis eines parasitären npn-Transistors dar, der in seiner Funktion nicht erwünscht ist. Dieser Spannungsanstieg wird durch eine geeignete Vorspannung am GATE-Anschluß des MOS-Transistors 19 über den durch die Widerstände 45,46,16 gebildeten Spannungsteiler reduziert, so daß die Ansprechempfindlichkeit der Transistoranordnung erhöht werden kann.

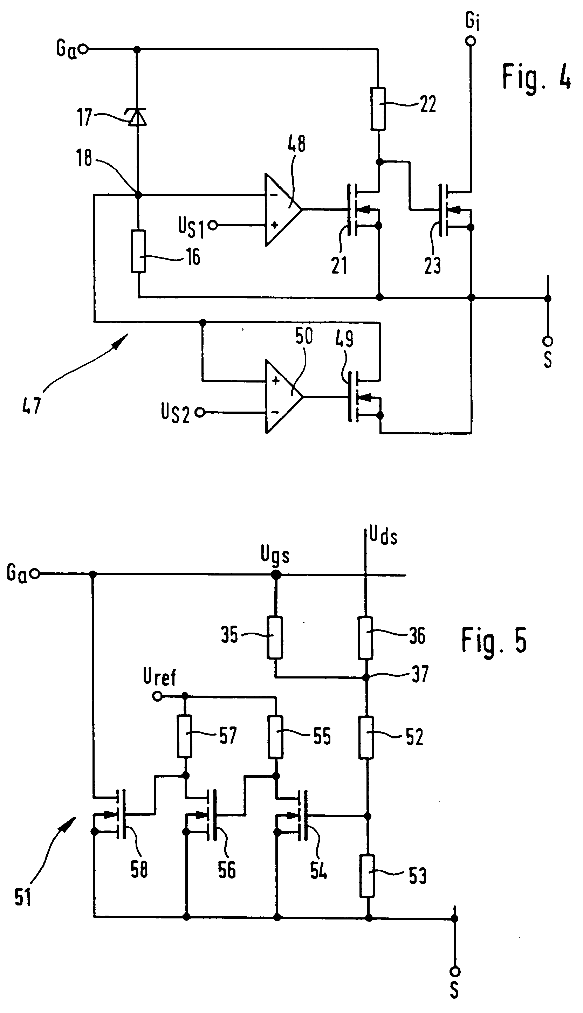

Bei dem in Fig. 4 dargestellten weiteren Ausführungsbeispiel einer Übertemperatur-Schutzeinrichtung 47 sind wiederum gleiche oder gleich wirkende Bauteile

mit denselben Bezugzeichen versehen und nicht nochmals beschrieben. Anstelle des MOS-Transistors 19 und des Widerstands 20 tritt nunmehr ein Verstärker 48, dessen invertierender Eingang mit dem Abgriff 18 verbunden ist. Der nichtinvertierende Eingang dieses Verstärkers 48 ist mit einer Vergleichsspannung $U_{S1}$ beaufschlagt. Der Ausgang dieses Verstärkers 48 steuert den MOS-Transistor 21. Weiterhin ist die DRAIN-SOURCE-Strecke eines weiteren MOS-Transistors 49 parallel zum temperaturabhängigen Widerstand 16 geschaltet. Dieser MOS-Transistor 49 wird über einen weiteren Verstärker 50 gesteuert, dessen nicht-invertierender Eingang am Abgriff 18 liegt und dessen invertierender Eingang mit einer Vergleichsspannung $U_{S2}$ beaufschlagt ist.

Der beschriebene Spannungsanstieg an der Anode der Z-Diode 17 wird hier dadurch begrenzt, daß die Auswertung des Signals am Abgriff 18 über den Verstärker 48 erfolgt, wobei die Vergleichsspannung $U_{S1}$ beispielsweise 100-150 mV beträgt. Dies bedeutet, daß der Spannungsanstieg an der Anode auf diesen Wert begrenzt wird. Die P-Wanne der Z-Diode 17 kann gleichzeitig zur Integration der übrigen Bauelemente für die Übertemperatur-Schutzschaltung benutzt werden. Zur sicheren Funktion ist hierzu eine Begrenzung der Spannung am Abgriff 18 auf einen Wert von weniger als 300 mV erforderlich. Diese Begrenzung bewirkt der zweite Verstärker 50, der bei Überschreiten der Vergleichsspannung $U_{S2}$ von beispielsweise 300 mV den hochohmigen Widerstand 16 niederohmig mit dem Masse- bzw. SOURCE-Anschluß verbindet. In einer einfacheren Ausgestaltung kann der Verstärker 50 und der MOS-Transistor 49 auch entfallen.

Bei den in den Fig. 3 und 4 dargestellten Ausführungsbeispielen kann selbstverständlich auch eine Hysterese gemäß Fig. 2 realisiert werden. Ebenfalls ist es möglich. diese Schaltungsvarianten zur Übertemperatur-Abregelung oder zur Übertemperatur-Abschaltung zu verwenden.

In Fig. 5 ist eine Ausführungsvariante einer Begrenzungsstufe 51 dargestellt, die anstelle der Begrenzungsstufe 34 in Fig. 1 treten kann. Gleiche oder gleich wirkende Bauteile sind mit denselben Bezugzeichen versehen und nicht nochmals beschrieben.

Der Summenpunkt 37 ist hier über einen aus zwei Widerständen 52,53 bestehenden Spannungsteiler mit dem SOURCE-Anschluß des Endstufenelements 10 verbunden. Der Abgriff zwischen den Widerständen 52,53 steuert den GATE-Anschluß eines MOS-Transistors 54, der zusammen mit einem Widerstand 55 eine Reihenschaltung bildet, die zwischen eine Referenzspannungsquelle Uref und den SOURCE-Anschluß S geschaltet ist. Der DRAIN-Anschluß dieses MOS-Transistors 54 steuert eine entsprechend geschaltete Reihenschaltung eines MOS-Transistors 56 mit einem Widerstand 57. Der DRAIN-Anschluß des MOS-Transistors 56 ist mit dem GATE-Anschluß eines weiteren MOS-Transistors 58 verbunden, dessen DRAIN-SOURCE-Strecke den äußeren GATE-Anschluß Ga mit dem SOURCE-Anschluß S des Endstufenelements 10 verbindet.

Durch den aus den beiden Widerständen 52,53 bestehenden Spannungsteiler wird das verlustleistungsproportionale Signal am Summenpunkt 37 so heruntergeteilt, daß es zur Ansteuerung der dreistufigen Transistoranordnung geeignet ist. Ab einem bestimmten Spannungswert, also ab einem bestimmten Verlustleistungswert, wird der MOS-Transistor 58 so weit in den stromleitenden Zustand versetzt, daß die Eingangsspannung Ugs und damit der Strom Id abgesenkt wird.

Die in Fig. 6 dargestellte alternative Schaltung zu Fig. 5 ist ähnlich aufgebaut, wobei gleiche oder gleich wirkende Bauteile mit denselben Bezugzeichen versehen und nicht nochmals beschrieben sind. Das Endstufenelement 10 und der GATE-Vorwiderstand 11 sind entsprechend Fig. 1 zusätzlich dargestellt. Der Widerstand 35 und die entsprechende Verbindung zum äußeren GATE-Anschluß Ga entfällt. Das Endstufenelement weist eine zusätzliche Sense-Zelle 59 auf, die mit dem Summenpunkt 37 verbunden ist. Dieser ist weiterhin über einen Widerstand 60 von der Referenzspannung Uref beaufschlagt. Der Widerstand 38 entfällt.

Alternativ zur Spannung Ugs wird hier eine Spannung als Maß für den DRAIN-Strom Id verwendet, die der von der Sense-Zelle 59 in den Summenpunkt 37 einfließende Sense-Strom Is = Id/k erzeugt. Zur Einstellung des Arbeitspunkts der Regelung dient dabei der Widerstand 60, der mit der Referenzspannungsquelle verbunden ist.

Selbstverständlich kann die Zuführung des Sense-Stroms zum Summenpunkt 37 anstelle der Spannung Ugs auch beim Ausführungsbeispiel gemäß Fig. 1 entsprechend eingesetzt werden.

Das beschriebene Endstufenbauteil in seinen verschiedenen dargestellten Varianten kann vollständig monolithisch integriert werden, insbesondere in der DMOS-Technik.

**Patentansprüche**

1. Monolithisch integriertes MOS-Endstufenbauteil, insbesondere DMOS-Endstufe, mit einem einen GATE-, einen SOURCE- und einen DRAIN-Anschluß aufweisenden Endstufenelement sowie mit einer Überlast-Schutzeinrichtung, wobei ein integrierter GATE-Vorwiderstand (11) vorgesehen ist, der einen äußeren GATE-Anschluß (Ga) des Endstufenbauteils mit dem GATE-Anschluß (Gi) des Endstufenelements (10) verbindet, und wobei die Überlast-Schutzeinrichtung im Endstufenbauteil integriert ist und eine durch definierte Durchströmung des GATE-Vorwiderstands (11) eine Verschiebung der Übertragungs-Kennlinie des Endstufenelements (10) um einen definierten Spannungs-Offsetwert erzeugende Pegelanpassungsstufe (30) sowie eine den Summenwert der DRAIN-SOURCE-Spannung und eine dem DRAIN-Strom proportionalen Spannung auf einen vorgebbaren Wert begrenzenden Begrenzungsstufe (34,51) aufweist.

2.  Endstufenbauteil nach Anspruch 1, dadurch gekennzeichnet, daß die Pegelanpassungsstufe (30) als Stromspiegel ausgebildet ist, deren erster Zweig den GATE-Anschluß (Gi) des Endstufenelements (10) mit dem SOURCE-Anschluß verbindet und dessen zweiter Zweig mit einem Referenzstrom beaufschlagt ist.

3.  Endstufenbauteil nach Anspruch 2, dadurch gekennzeichnet, daß eine Referenzspannungsquelle (24) mit dem zweiten Zweig verbunden ist.

4.  Endstufenbauteil nach Anspruch 3, dadurch gekennzeichnet, daß die Referenzspannungsquelle (24) vom äußeren GATE-Anschluß (Ga) gespeist wird.

5.  Endstufenbauteil nach einem der Ansprüche 2 bis 4, dadurch gekennzeichnet, daß die beiden Zweige des Stromspiegels durch zwei MOS-Transistoren (31,32) gebildet werden.

6.  Endstufenbauteil nach einem der vorhergehenden Ansprüche, dadurch gekennzeichnet, daß eine die DRAIN-SOURCE-Spannung mit der GATE-SOURCE-Spannung als dem DRAIN-Strom proportionale Spannung additiv verknüpfende Addierstufe (35.36.37) vorgesehen ist.

7.  Endstufenbauteil nach Anspruch 6, dadurch gekennzeichnet, daß die Addierstufe aus zwei einseitig miteinander verbundenen Widerständen (35,36) besteht, über die die beiden Spannungen zu einem Summenpunkt (37) zusammengeführt sind.

8.  Endstufenbauteil nach einem der Ansprüche 1 bis 5, dadurch gekennzeichnet, daß das Endstufenelement (10) eine einen Sense-Strom liefernde Sense-Zelle (59) aufweist und daß eine die DRAIN-SOURCE-Spannung mit einer dem Sense-Strom proportionalen Spannung als dem DRAIN-Strom proportionale Spannung additiv verknüpfende Addierstufe (36,37) in der Begrenzungsstufe vorgesehen ist.

9.  Endstufenbauteil nach Anspruch 8, dadurch gekennzeichnet, daß die Addierstufe (36, 37) aus einem mit der DRAIN-SOURCE-Spannung beaufschlagten, mit einem Summenpunkt (37) verbundenen Widerstand (36) besteht, wobei der Summenpunkt (37) mit der Sense-Zelle (59) des Endstufenelements (10) verbunden ist.

10. Endstufenbauteil nach einem der vorhergehenden Ansprüche, dadurch gekennzeichnet, daß die Begrenzungsstufe (34,51) Mittel zur Reduzierung des Widerstandes eines zwischen den äußeren GATE-Anschluß (Ga) und den SOURCE-Anschluß geschalteten MOS-Transistors (40; 58) bei ansteigendem Summenwert aufweist.

11. Endstufenbauteil nach Anspruch 10, dadurch gekennzeichnet, daß die Mittel als vergleichender Regelverstärker (39) ausgebildet sind, dem neben dem Summenwert ein festlegbarer Grenzwert ($U_{S3}$) zugeführt ist.

12. Endstufenbauteil nach Anspruch 10, dadurch gekennzeichnet, daß die Mittel als mehrstufiger MOS-Regelverstärker (54-58) ausgebildet sind, der mittels eines Spannungsteilers (52,53) durch einen festlegbaren Teil des Summenwerts gesteuert ist.

13. Endstufenbauteil nach einem der vorhergehenden Ansprüche, dadurch gekennzeichnet, daß die Pegelanpassungsstufe (30) zur Ausbildung einer Steuerkennlinie Id = f (Ugs) mit negativem Temperatur-Koeffizienten ausgelegt ist.

14. Endstufenbauteil nach einem der vorhergehenden Ansprüche, dadurch gekennzeichnet, daß ein DRAIN-SOURCE-Spannungsbegrenzer (Klammerung) (12) für das Endstufenelement (10) vorgesehen ist.

15. Endstufenbauteil nach einem der vorhergehenden Ansprüche, dadurch gekennzeichnet, daß zusätzlich eine Übertemperatur-Schutzeinrichtung (15; 41; 44; 47) im Endstufenbauteil integriert ist.

16. Endstufenbauteil nach Anspruch 15, dadurch gekennzeichnet, daß die Übertemperatur-Schutzeinrichtung (15; 41; 44; 47) eine Reihenschaltung einer Z-Diode (17) mit einem temperaturabhängigen Widerstand (16) mit positivem Temperatur-Koeffizienten aufweist, der am SOURCE-Anschluß (S) liegt, wobei diese Reihenschaltung mit einer Versorgungsspannung beaufschlagt ist, und daß eine von einer Steuerspannung am Abgriff (18) der Reihenschaltung gesteuerte Halbleiteranordnung zur Reduzierung der GATE-Spannung beim Auftreten von Übertemperaturen vorgesehen ist.

17. Endstufenbauteil nach einem der vorhergehenden Ansprüche, gekennzeichnet durch modulartige Parallschaltung mit wenigstens einem weiteren Endstufenbauteil.

**Claims**

1.  Monolithically integrated MOS output stage component, in particular DMOS output stage, with an output state element having a GATE, a SOURCE and a DRAIN terminal as well as with an overload protection device, an integrated GATE series resistor (11) being provided, which connects an external GATE terminal (Ga) of the output stage component to the GATE terminal (Gi) of the output stage element (10), and the overload protection device being integrated in the output stage component and having a level matching stage (30), which produces a shift in the transfer characteristic of the output stage element (10) by a defined voltage offset value as a result of a defined throughflow of the GATE series resistor (11), as well as a limiting stage (34, 51), which limits the summation value of the DRAIN-SOURCE voltage and a voltage which is proportional to the DRAIN current to a predeterminable value.

2. Output stage component according to Claim 1, characterized in that the level matching stage (30) is designed as a current mirror, the first path of which connects the GATE terminal (Gi) of the output stage element (10) to the source terminal and the second path of which has a reference current applied to it.

3. Output stage component according to Claim 2, characterized in that a reference voltage source (24) is connected to the second path.

4. Output stage component according to Claim 3, characterized in that the reference voltage source (24) is fed from the external GATE terminal (Ga).

5. Output stage component according to one of Claims 2 to 4, characterized in that the two paths of the current mirror are formed by two MOS transistors (31, 32).

6. Output stage component according to one of the preceding claims, characterized in that provision is made of an addition stage (35, 36, 37), which additively combines the DRAIN-SOURCE voltage with the GATE-SOURCE voltage as voltage which is proportional to the DRAIN current.

7. Output stage component according to Claim 6, characterized in that the addition stage comprises two resistors (35, 36) which are connected to one another at one end and via which the two voltages are brought together to a summation point (37).

8. Output stage component according to one of Claims 1 to 5, characterized in that the output stage element (10) has a sense cell (59) which supplies a sense current, and in that an addition stage (36, 37), which additively combines the DRAIN-SOURCE voltage with a voltage which is proportional to the sense current as voltage which is proportional to the drain current, is provided in the limiting stage.

9. Output stage component according to Claim 8, characterized in that the addition stage (36, 37) comprises a resistor (36) which has the drain-source voltage applied to it and is connected to a summation point (37), the summation point (3) being connected to the sense cell (59) of the output stage element (10).

10. Output stage component according to one of the preceding claims, characterized in that the limiting stage (34, 51) has means for reducing the resistance of a MOS transistor (40; 58), which is connected between the external GATE terminal (Ga) and the SOURCE terminal, in the case of a rising summation value.

11. Output stage component according to Claim 10, characterized in that the means are designed as a comparative control amplifier (3), to which a definable limit value ($U_{S3}$) is fed in addition to the summation value.

12. Output stage component according to Claim 10, characterized in that the means are designed as a multistage MOS control amplifier (54-58), which is controlled, by means of a voltage divider (52, 53), by a definable part of the summation value.

13. Output stage component according to one of the preceding claims, characterized in that the level matching stage (30) is designed for forming a control characteristic Id = f (Ugs) with a negative temperature coefficient.

14. Output stage component according to one of the preceding claims, characterized in that provision is made of a DRAIN-SOURCE voltage limiter (clamping) (12) for the output stage element (10).

15. Output stage component according to one of the preceding claims, characterized in that an overtemperature protection device (15; 41; 44; 47) is additionally integrated in the output stage component.

16. Output stage component according to Claim 15, characterized in that the overtemperature protection device (15; 41; 44; 47) has a series circuit formed by a Z diode (17) and a thermistor (16) having a positive temperature coefficient, which thermistor is connected to the SOURCE terminal (S), a supply voltage being applied to this series circuit, and in that a semiconductor arrangement, which is controlled by a control voltage at the tap (18) of the series circuit, for reducing the GATE voltage when overtemperatures occur is provided.

17. Output stage component according to one of the preceding claims, characterized by module-like connection in parallel with at least one further output stage component.

## Revendications

1. Composant d'étage de sortie MOS intégré, monolithique notamment étage de sortie DMOS comprenant un composant d'étage de sortie avec une borne de GRILLE, une borne de SOURCE et une borne de DRAIN ainsi qu'une installation anti-surcharge,

   une résistance intermédiaire (11) de GRILLE intégrée reliant une borne externe de GRILLE (Ga) du composant d'étage de sortie à la borne de GRILLE (G i) du composant d'étage de sortie (10),
   l'installation anti-surcharge intégrée au composant d'étage de sortie, comportant un étage adaptateur de niveau (30) qui par un passage de courant défini dans la résistance intermédiaire de GRILLE (11) produit un décalage de la caractéristique de transfert du composant d'étage de sortie (10), d'une valeur de décalage de tension, déterminée, ainsi qu'un étage limiteur (34, 51) qui limite la valeur de la somme de la tension DRAIN-SOURCE et d'une tension proportionnelle au courant de DRAIN à une valeur prédéterminée.

2. Composant d'étage de sortie selon la revendication 1,
   caractérisé en ce que
   l'étage adaptateur de niveau (30) est réalisé sous forme d'un miroir de courant dont la première branche comprend la borne de GRILLE (Gi) du composant d'étage de sortie (10) reliée à la borne de SOURCE dont la seconde branche reçoit un courant de référence.

3. Composant d'étage de sortie selon la revendication 2,
   caractérisé en ce qu'
   une source de tension de référence (24) est reliée à la seconde branche.

4. Composant d'étage de sortie selon la revendication 3,
   caractérisé en ce que
   la source de tension de référence (24) est alimentée par la borne extérieure de GRILLE (Ga).

5. Composant d'étage de sortie selon l'une des revendications 2 à 4,
   caractérisé en ce que
   les deux branches du miroir de courant sont formées par deux transistors MOS (31, 32).

6. Composant d'étage de sortie selon l'une des revendications précédentes,
   caractérisé par
   un étage additionneur (35, 36, 37) combinant de manière additive la tension DRAIN-SOURCE à la tension GRILLE-SOURCE comme tension proportionnelle à l'intensité à travers le DRAIN.

7. Composant d'étage de sortie selon la revendication 6,
   caractérisé en ce que
   l'étage additionneur se compose de deux résistances (35, 36) reliées par une extrémité et qui réunissent les deux tensions en un point d'addition (37).

8. Composant d'étage de sortie selon l'une des revendications 1 à 5,
   caractérisé en ce que
   le composant d'étage de sortie (10) comporte une cellule de détection (59) pour fournir un courant détecté et un étage additionneur (36, 37) prévu dans le chemin limiteur pour combiner par addition la tension DRAIN-SOURCE à une tension proportionnelle au courant détecté, comme tension proportionnelle à l'intensité du DRAIN.

9. Composant d'étage de sortie selon la revendication 8,
   caractérisé en ce que
   l'étage additionneur (36, 37) se compose d'une résistance (36) recevant la tension DRAIN-SOURCE, et reliée à un point d'addition (37), ce point (37) étant relié à la cellule de détection (59) du composant d'étage de sortie (10).

10. Composant d'étage de sortie selon l'une quelconque des revendications précédentes,
    caractérisé en ce que
    l'étage limiteur (34, 51) comprend des moyens pour réduire la résistance d'un transistor MOS (40, 58) branché entre la borne externe de GRILLE (Ga) et la borne de SOURCE d'un transistor MOS (40, 58) lorsque la valeur de somme augmente.

11. Composant d'étage de sortie selon la revendication 10,
    caractérisé en ce que
    les moyens sont constitués par un amplificateur régulateur et comparateur (39) recevant non seulement la somme mais également une valeur limite fixée ($U_{S3}$).

12. Composant d'étage de sortie selon la revendication 10,
    caractérisé en ce que
    les moyens sont constitués par un amplificateur de régulation MOS (54, 58) à plusieurs étages, commandé par un diviseur de tension (52, 53) par une partie fixée de la valeur d'addition.

13. Composant d'étage de sortie selon l'une des revendications précédentes,
caractérisé en ce que
l'étage adaptateur de niveau (30) est conçu pour réaliser une caractéristique de commande Id = f (Ugs) d'un coefficient d'opération négatif.

14. Composant d'étage de sortie selon l'une des revendications précédentes,
caractérisé par
un limiteur de tension DRAIN-SOURCE (tension écrêtée) (12) pour le composant de l'étage de sortie (10).

15. Composant d'étage de sortie selon l'une des revendications précédentes,
caractérisé en ce qu'
en outre une installation de protection contre la température excessive (15, 41, 44, 47) est intégrée dans le composant de l'étage de sortie.

16. Composant d'étage de sortie selon la revendication 15
caractérisé en ce que
l'installation de protection contre la température excessive (15, 41, 44, 47) comprend un montage en série d'une diode Z, (17) et une résistance (16) dépendant de la température d'un coefficient de température positif reliée à la borne de SOURCE (S), ce montage en série recevant une tension d'alimentation et, un dispositif semi-conducteur commandé par la tension de commande à la prise (18) du montage en série est prévu pour réduire la tension de GRILLE à l'arrivée en cas de température excessive.

17. Composant d'étage de sortie selon l'une des revendications précédentes,
caractérisé par
un branchement en parallèle modulaire avec au moins un autre composant d'étage de sortie.

Fig. 1

EP 0 623 257 B1

Fig. 2

Fig. 3

Fig. 4

Fig. 5

# Fig. 6